# EUROPEAN PATENT APPLICATION

(11) **EP 4 513 540 A1**
(43) Date of publication of application: **26.02.2025**
(21) Application number: 23192401.0
(22) Date of filing: 21.08.2023
(51) Int. Cl.: H01L 21/768

(54) **A SEMICONDUCTOR INTERCONNECTED DEVICE AND A METHOD OF PRODUCING THE SAME**

(71) Applicant: Epinovatech AB, 223 63 Lund (SE)
(72) Inventor: OLSSON, Martin Andreas, 223 63 Lund (SE)
(74) Representative: Zacco Sweden AB

(57) **Abstract**

Here is provided semiconductor device comprising: a substrate; a nitride semiconductor layer arranged on the substrate; a blind via being an electrical connection from a backside of the substrate to the nitride semiconductor layer, the blind via comprising a first portion of a metal contact, the first portion being arranged in a hole through the substrate; a first electrical insulator separating the first portion of the metal contact from the substrate, wherein at least a part of the first electrical insulator is part of a lateral wall of the hole.

## Description

### Technical field

The present inventive concept relates to, in general, a semiconductor interconnected device and a method for producing a semiconductor interconnected device.

### Background

Gallium nitride (GaN) material is the basis of high power and radio frequency (RF) HEMT field-effect transistors. GaN growth on silicon offer economies of scale compared to alternative substrates such as silicon carbide. Vertical GaN devices offer a reduction in the die size contrary to lateral GaN devices. This is especially important in the field of new power efficient electronics offering sustainability to conventional silicon electronics.

There is room for improvement in the prior art for vertically integrated GaN device architectures and its integration on large area wafers.

### Summary of the invention

It is an objective of the present inventive concept to provide a semiconductor device for isolating current transport. These and other objectives of the inventive concept are at least partly met by the invention as defined in the independent claims. Preferred embodiments are set out in the dependent claims.

In this text, abbreviations of the natural elements will be used in accordance with the periodic table. For example, Al means aluminum, Ga means gallium, N means nitrogen, As means arsenic, Mg means magnesium, O means oxygen, Si means silicon, C means carbon.

According to a first aspect, there is provided a semiconductor device comprising:
a substrate;
a nitride semiconductor layer arranged on the substrate;
a blind via being an electrical connection from a backside of the substrate to the nitride semiconductor layer, the blind via comprising a first portion of a metal contact, the first portion being arranged in a hole through the substrate;
a first electrical insulator separating the first portion of the metal contact from the substrate, wherein at least a part of the first electrical insulator is part of a lateral wall of the hole.

It is a realization that a semiconductor device may have a first electrical insulator for separating a metal contact from the substrate. It is a further realization that an semiconductor device may have a metal contact extending from the backside of the substrate to a semiconductor layer of the device.

The device may be a vertical high-electron-mobility transistor, vertical HEMT, device.

The semiconductor device may comprise a first transistor, e.g. a high-electron-mobility transistor (HEMT), such as a vertical HEMT. The blind via may be connected to the source or drain of the first transistor. The blind via may be part of an interconnect between two transistors, e.g. between the first transistor and a second transistor of the semiconductor device.

Thanks to the blind via entering the semiconductor device from the backside of the substrate, a semiconductor device comprising a first transistor may be more compact compared to a blind via entering from the frontside of the device.

The device may be used for drain contact isolation. In other words, the semiconductor interconnected device may be connected to a transistor. The connection may be made to isolate power leakage from the drain through the substrate into a close by transistor.

As used herein, the term nitride semiconductor material should be construed as any semiconductor material comprising nitrogen, in particular alloys of group III and V in the periodic table where the group V part is nitrogen. The nitride semiconductor material may be GaN based material. As used herein, the term "GaN based material" should be construed as any semiconductor material comprising gallium and nitrogen, e.g. GaN, AlGaN, InGaN, AlnGaN.

In other words, the nitride semiconductor layer may comprise AI(x)Ga(1-x)N, wherein the composition x is 0<x<1. The nitride semiconductor layer may comprise AI(y)Ga(1-y)N, wherein the composition y is 0 ≤y<0.5.

The nitride semiconductor layer may comprise a sputtered AIN layer. A sputtered AlN layer may be polycrystalline. Thus, the nitride semiconductor layer may comprise a polycrystalline AlN layer. A polycrystalline AlN layer (e.g. sputtered AIN layer) may have a higher etch rate than a single crystalline AlN layer (e.g. a AIN layer grown by metalorganic vapour-phase epitaxy (MOCVD).

GaN based material may facilitate high-frequency operation and/or high-power operation and/or high-temperature operation and/or high voltage operation.

At least a part of the first electrical insulator is part of a surface facing the blind via. It should be understood that the first electrical insulator faces the metal contact in the blind via, at the position where the blind via passes through the substrate. Thus, the first electrical insulator is insulating the substrate from the metal contact. This allows electricity to travel through the device. It should be understood that the first electrical insulator may be comprised in the substrate. In other words, the first electrical insulator may be a part of the substrate.

However, the first electrical insulator may be a separate material compared to the substrate.

The substrate may be a silicon substrate. Thus, the substrate may comprise silicon with the crystallographic orientation <111>. The silicon may be p-doped silicon. The first electrical insulator may comprise silicon oxide. A silicon substrate may be a cheap substrate for nitride semiconductor growth. A silicon substrate facilitates integration with silicon based electronics. It is a realization that nitride semiconductor growth is facilitated if the silicon substrate is p-doped. However, p-doped silicon may conduct current. Thus, the first electrical insulator may prevent current from passing from the first portion of the metal, through the substrate, to an electrical component situated elsewhere.

The first electrical insulator may comprise silicon oxide.

The first electrical insulator may be an oxidized lateral wall of the hole facing the first portion of the metal contact. In other words, part of the lateral wall of the hole, facing the first portion of the metal contact, may be an oxidized material.

The first electrical insulator may be separate from the substrate. However, the first electrical insulator may also be comprised in the substrate.

In other words, the substrate may be a silicon substrate which in a portion is oxidized to create the first electrical insulator. The first electrical insulator may be an oxidized lateral wall of the hole through the substrate. Thus, a hole through the substrate may first be formed and the lateral walls of the hole may subsequently be oxidized. Thus, substrate material at the lateral wall of the hole may be converted into the first electrical insulator during manufacturing. Material of an oxidized lateral wall may be epitaxially aligned with crystalline material of the substrate. For example, when a silicon lateral wall of the hole is oxidized into silicon oxide, said silicon oxide may be epitaxially aligned with the rest of the substrate. Such an oxidized lateral wall may provide good electrical insulation. Further, such an oxidized lateral wall may be created by in-situ oxidation in a plasma etch chamber after plasma etching of the hole. Thus, the lateral walls of the hole may be oxidized without the sample leaving the plasma chamber. This may prevent native oxide from forming between etching of the hole and plasma oxidation, thereby charge traps may be avoided. Further, in-situ oxidation may provide a more efficient production method, as few production steps are needed, and thereby a cheap device.

As an alternative, the first electrical insulator may be an electrical insulator deposited on inner walls of the hole through the substrate. Such deposited electrical insulator may have no or little epitaxial alignment with the substrate.

The metal contact may further comprise a second portion. The second portion may extend along the backside of the substrate. In other words, the metal contact may have T form. The T form may extend vertically through the blind via from the backside of the substrate into the semiconductor layer and extend horizontally along the backside of the substrate. The horizontally extending metal contact may connect to further devices.

However, it should be understood that other geometries of the metal contact is possible.

The device may further comprise a second electrical insulator. The second electrical insulator may be arranged on the backside of the substrate, between the backside of the substrate and the second portion of the metal contact. The second electrical insulator may insulate the substrate from the second portion of the metal contact. The second electrical insulator may be a passivation layer. The second electrical insulator may comprise aluminum nitride, silicon nitride, or silicon oxide. The silicon dioxide (SiO₂), may be dry oxidized using a plasma oxidation. In one example of the invention, one or more RF power amplifiers formed based on a HEMT epistructure supported by the frontside of the substrate whereas the same power amplifiers may be integrated in a cascade amplifier. Three or more power amplifiers may be integrated together and being isolated from each other with respect to the drain of the same power amplifier devices.

The nitride semiconductor layer may comprise a first layer and a second layer. The first layer may be arranged between the second layer and the substrate. The first layer may have a higher aluminum content than the second layer. The first layer may comprise AI(x)Ga(1-x)N, wherein the composition x is 0.5<x≤1. The second layer may comprise AI(y)Ga(1-y)N, wherein the composition y is 0≤y<0.5.

The first layer may for instance be an AIN layer. The second layer may be a AlGaN layer. Alternatively, the second layer may be a GaN layer.

The nitride semiconductor layer may comprise an AIGaN/GaN interface. Such an interface may, during operation, form a 2-dimensional electron gas, 2DEG. Said 2DEG may be formed by applying a voltage to a gate contact connected to the device. Thus, electrical conduction at the interface between the AlGaN-layer and the GaN-layer may be switched on and off by a gate contact.

The nitride semiconductor layer may comprise more than two layers. For example, the nitride semiconductor layer may comprise an AIN layer (e.g. sputtered AIN) on the substrate, followed by an AlGaN layer, followed by a GaN layer. In this case, the interface between the AlGaN and the GaN layer may be the AIGaN/GaN interface that forms the 2DEG.

The nitride semiconductor layer may comprise an etch stop layer. The etch stop layer may be comprised in the second layer. In other words, the etch stop layer may be arranged to extend horizontally through the second layer.

As a first alternative, the etch stop layer may comprise AIN.

As a second alternative, the etch stop layer may comprise In(z)Ga(1-z)N as a spectroscopic marker where 0.01 < z < 0.10. During plasma etching of the In(z)Ga(1-z)N layer Indium species becomes byproduct gases that may provide a spectroscopic fingerprint for the determination that the etch back has reached the desired etch depth.

A thickness of the first electrical insulator may be 100-500 nm. The thickness of the first electrical insulator being a thickness separating the first portion of the metal contact from the substrate. In other words, the first electrical insulator may extend horizontally into the device for a length of 100-500 nm. Thus, the first electrical insulator may extend 100, 200, 300, 400 or 500 nm horizontally into the device.

The metal contact may be configured to provide an ohmic contact to the nitride semiconductor to which the metal contact connects, and hence provide a vertical connection to a frontside chip architecture.

According to a second aspect, there is provided a method for producing a semiconductor device, the method comprising:
forming a nitride semiconductor layer on a frontside of a substrate;
forming a hole through the substrate, from the backside of the substrate to the nitride semiconductor layer;
forming a first electrical insulator, such that at least a part of the first electrical insulator is part of a lateral wall of the hole;
depositing metal on the backside of the substrate to form a metal contact, the metal contact having a first portion in the hole through the substrate, such that the first portion of the metal contact forms part of a blind via being an electrical connection from the backside of the substrate to the nitride semiconductor layer, wherein the first electrical insulator separates the first portion of the metal contact from the substrate.

The method may provide with the same advantages as the first aspect.

The blind via allows for the metal contact to extend through the substrate and to the nitride semiconductor layer. Thanks to the first electrical insulator, the substrate is insulated from the metal contact.

The method provides with an advantage when a plurality of devices are arranged closely to each other, where the functioning of each chip may be ensured thanks to the first electrical insulation. One or more devices, e.g. GaN devices, may be arranged closely to each other as power amplifiers, PAs, and be configured as 3-finger GaN HEMT devices. This may be advantageous for providing monolithic microwave integrated circuits, MMIC, with a high energy efficiency and large bandwidth such as for 5G cellular communication chipsets.

The hole may be formed by plasma etching, such as deep reactive ion etching.

The forming of the first electrical insulator may be made by oxidizing the lateral wall of the hole. This may be done by dry oxidation using an oxygen plasma.

The method may further comprise depositing a second electrical insulator on the backside of the substrate, before forming the hole.

The nitride semiconductor layer may comprise a first layer and a second layer. The first layer may be arranged between the second layer and the substrate. The first layer may have a higher aluminum content than the second layer. The first layer of the nitride semiconductor layer may be formed by sputtering.

The nitride semiconductor layer may comprise AI(x)Ga(1-x)N, wherein the composition x is 0<x≤1. The nitride semiconductor layer may comprise AI(y)Ga(1-y)N, wherein the composition y is 0≤y<0.5.

The first layer of the nitride semiconductor layer may be sputtered epitaxially aligned with the crystal orientation of the substrate, preferably wherein said substrate is silicon <111>.

The method may further comprise, after forming the first electrical insulator and before depositing the metal,
expanding the hole into the nitride semiconductor layer. The expansion of the hole may for instance be made into the second layer of the nitride semiconductor layer. This is highly advantageous as nitride semiconductor material with high dislocation density near the vicinity of the interface may be removed to access low dislocation material distal to the same interface. This may also provide improved ohmic contact.

The nitride semiconductor layer may comprise an etch stop layer. The in situ etch stop is an In(z)Ga(1-z)N epilayer. By using the in situ etch stop layer, the reactive ion etching may be stopped at the right time by using spectroscopy measurement.

The method may further comprise stopping the expansion of the hole at the etch stop layer.

The second electrical insulator may be deposited by atomic layer deposition or plasma-enhanced chemical vapor deposition.

The forming of the first electrical insulator may be made by oxidizing the substrate. The oxidizing of the substrate may be made by dry oxidizing made with an oxygen plasma.

The metal layer may be deposited by sputtering or by evaporation.

### Brief description of the drawings

The above, as well as additional objects, features and advantages of the present inventive concept, will be better understood through the following illustrative and non-limiting detailed description, with reference to the appended drawings. In the drawings like reference numerals will be used for like elements unless stated otherwise.
Fig. 1 illustrates a semiconductor device.
Fig. 2 comprises a flow chart of a method.
Fig. 3a-3f illustrates a method of producing a semiconductor device.
Fig. 4 illustrated a semiconductor device.

### Detailed description

In cooperation with attached drawings, the technical contents and detailed description of the present invention are described thereinafter according to a preferable embodiment, being not used to limit the claimed scope. This invention may be embodied in many different forms and should not be construed as limited to the embodiments set forth herein; rather, these embodiments are provided for thoroughness and completeness, and fully convey the scope of the invention to the skilled person.

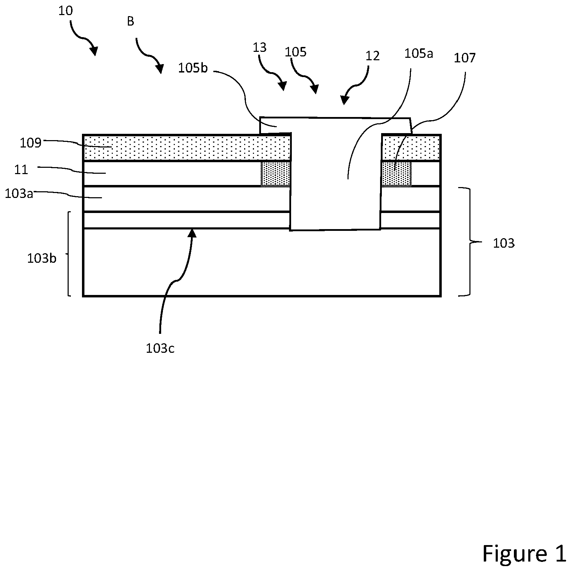

Fig. 1 illustrates a cross section of a semiconductor device 10. The device 10 may be a vertical high-electron-mobility transistor, vertical HEMT, device.

The device comprises a substrate 11. The substrate 11 may comprise silicon. The substrate 11 may be a silicon substrate. The silicon may be p-doped silicon.

The device 10 further comprises a nitride semiconductor layer 103 arranged on the substrate 11. The nitride semiconductor layer 103 may comprise a first layer 103a and a second layer 103b. The first layer 103a being arranged between the second layer 103b and the substrate 11. The first layer may 103a have a higher aluminum content than the second layer 103b.

The nitride semiconductor layer 103 may comprise AI(x)Ga(1-x)N, wherein the composition x is 0<x≤1. The nitride semiconductor layer 103 may comprise AI(y)Ga(1-y)N, wherein the composition y is 0≤y<0.5.

The nitride semiconductor layer 103 may comprise a etch stop layer 103c. The etch stop layer 103c may be comprised in the second layer 103b. In other words, the etch stop layer 103c may be arranged to extend horizontally through the second layer 103b. The etch stop layer 103c may comprise In(z)Ga(1-z)N having the composition z, where 0.01 < z < 0.10. It should be understood that the etch stop layer 103c may be arranged at another position in the nitride semiconductor layer 103 and the positioning in the Fig. 1 is only one possible example.

The device 10 further comprises a blind via 12. The blind via 12 being an electrical connection from a backside or rear side B of the substrate 11 to the nitride semiconductor layer 103. Thus, the blind via provides a rear side connection to e.g. GaN.

The blind via 12 comprises a first portion 105a of a metal contact 105. The first portion 105a being arranged in a hole 13 through the substrate 11. The metal contact 105 may be configured to provide an ohmic contact to the nitride semiconductor 103 to which the metal contact 105 connects.

The substrate 11 comprises a first electrical insulator 107 separating the first portion 105a of the metal contact from the substrate 12. At least a part of the first electrical insulator 107 is part of a lateral wall of the hole 13.

The first electrical insulator 107 may comprise silicon oxide. The first electrical insulator 107 may be an oxidized lateral wall of the hole 13. The substrate 11 may be a silicon substrate 11 which in a portion is oxidized to create the first electrical insulator 107. The first electrical insulator 107 may be an oxidized lateral wall of the hole 13 through the substrate 11. Thus, a hole 13 through the substrate may first be formed and the lateral walls of the hole 13 may subsequently be oxidized. As an alternative, the first electrical insulator 107 may be an electrical insulator deposited on inner walls of the hole 13 through the substrate 11. Such deposited electrical insulator may have no or little epitaxial alignment with the substrate 11.

The first electrical insulator 107 may have a thickness of 100-500 nm. The thickness of the first electrical insulator 107 being a thickness separating the first portion 105a of the metal contact 105 from the substrate 11.

The metal contact 105 may further comprise a second portion 105b. The second portion 105b may extend along the backside of the substrate 11. In Fig. 1 the first portion 105a of the metal contact 105 and the second portion of the metal contact 105b forms the shape of a T. However, it should be realized that the relation between the first portion 105a and the second portion 105b of the metal contact 105 may vary.

The device 10 may further comprises a second electrical insulator 109. The second electrical insulator may be arranged on the backside B of the substrate 11, between the backside B of the substrate 11 and the second portion 105b of the metal contact 105. The second electrical insulator 109 may insulate the substrate 11 from the second portion 105b of the metal contact 105. The second electrical insulator 109 may be a passivation layer. The second electrical insulator 109 may comprise aluminum nitride, silicon nitride, or silicon oxide. The silicon dioxide (SiO₂), may be dry oxidized using a plasma oxidation.

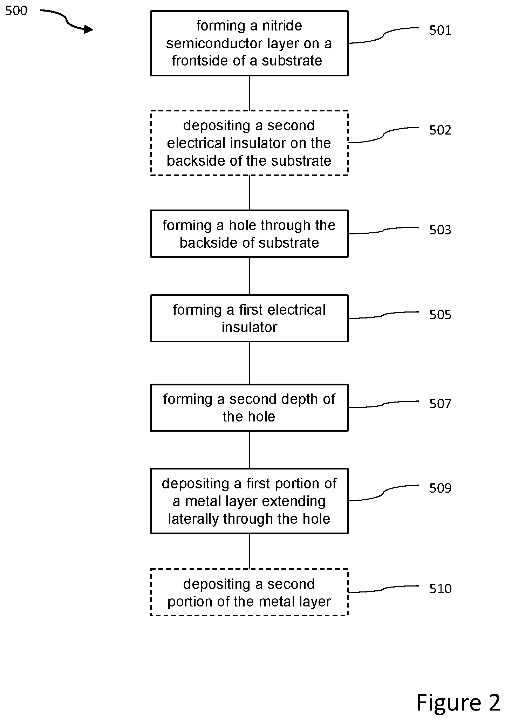

Fig. 2 illustrates a flowchart of a method 500 for producing a semiconductor interconnected device 10.

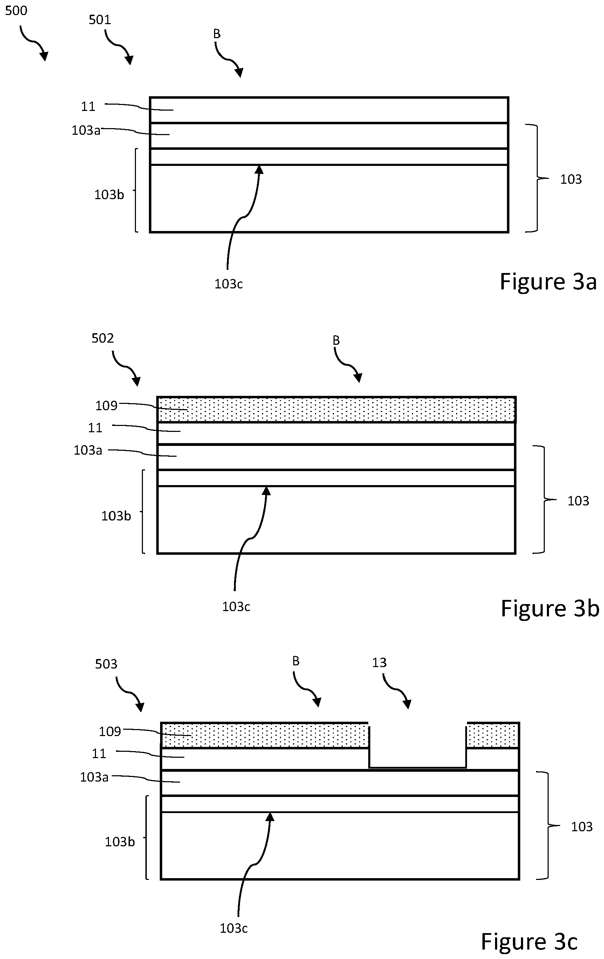

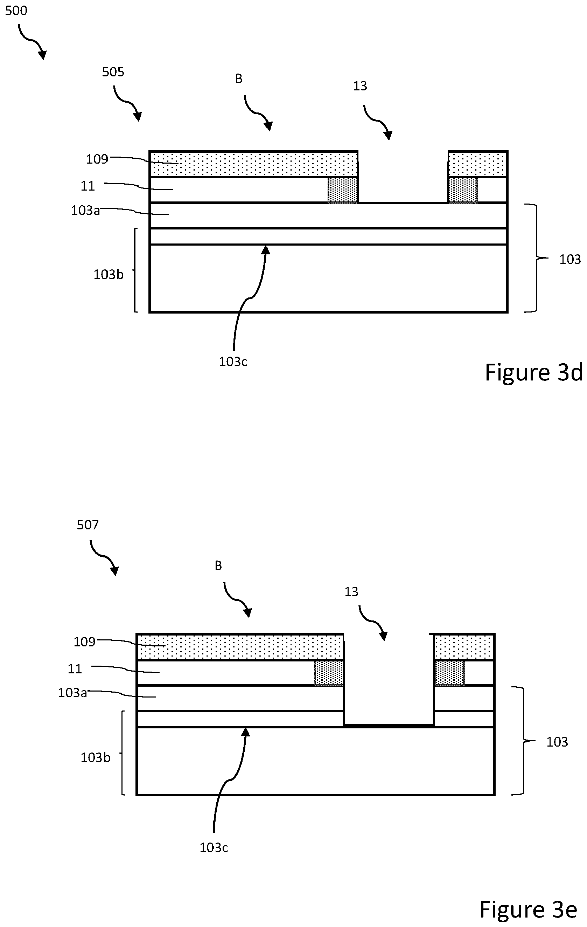

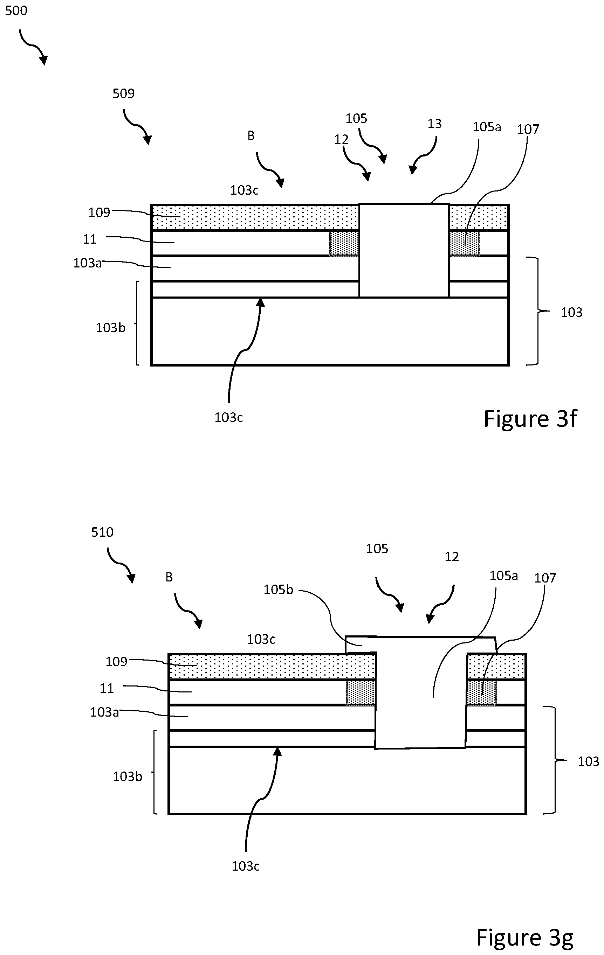

Fig. 3a-g illustrates a method 500 for producing a semiconductor interconnected device 10.

Fig. 2 and Fig. 3a-3g will be discussed below.

The method 500 comprises forming 501 a nitride semiconductor layer 103 on a frontside of a substrate 11. The nitride semiconductor layer 103 may comprise a first layer 103a and a second layer 103b. The first layer 103a being arranged between the second layer 103b and the substrate 11. The first layer 103a may have a higher aluminum content than the second layer 103b. The first layer 103a of the nitride semiconductor layer 103 may be formed by sputtering.

Further, the nitride semiconductor layer 103c may comprise an etch stop layer 103c. The in situ etch stop layer 103c may be an In(z)Ga(1-z)N epilayer.

Optionally, the method 500 may further comprise depositing 502 a second electrical insulator 109 on the backside of the substrate 11.

Further, the method 500 comprises forming 503 a hole 13 through the substrate. The hole 13 extending from the backside of substrate 11 to the nitride semiconductor layer 103.

The hole 13 is formed 503 after the deposition 502 of the second electrical insulator 109, if such is present.

The hole 13 may be formed by plasma etching, such as deep reactive ion etching.

Further, the method comprises forming 505 a first electrical insulator 107, such that at least a part of the first electrical insulator 107 is part of a lateral wall of the hole 13. The first electrical insulator 107 creates a separation between the substrate 11 and the first portion 105a of the metal contact 105.

The forming 505 of the first electrical insulator 107 may be made by oxidizing a lateral wall of the hole 13. The oxidizing of the lateral wall of the hole 13 may be made by dry oxidation using an oxygen plasma

The method 500 may optionally further comprise, after forming 505 the first electrical insulator 107 and before depositing 509 metal, expanding the hole 13 into the nitride semiconductor layer 103. The expansion of the hole 13 may be stopped at the etch stop layer 103c.

Further, the method comprises depositing 509 metal on the backside B of the substrate 11 to form a metal contact 105. The metal contact 105 having a first portion 105a in the hole 13 through the substrate 11. The first portion 105a of the metal contact 105 forms part of a blind via 12 being an electrical connection from the backside B of the substrate 11 to the nitride semiconductor layer 103. The first electrical insulator 107 separates the first portion 105a of the metal contact from the substrate 11.

Further, the metal contact 105 may have a second portion 105b extending horizontally along the backside of the substrate 11.

In one example of the invention, a Doherty amplifier may comprise two or more semiconductor devices according with the invention to arrange drain contacts on the backside of a silicon substrate. Interconnect between the two GaN HEMT devices may be provided by through-hole vias. The Doherty amplifier may combine two power amplifier HEMT devices arranged on the same substrate that are monolithically integrated. The first GaN HEMT device may be a carrier amplifier and the second peaking amplifier.

In another example of the invention, a GaN power device, may be arranged as a vertical GaN transistor on a silicon substrate. The vertical GaN power device may comprise a metal drain contact (105) of a vertical GaN device, such as a FinFET, Current Aperture Vertical Electron Transistor, vertical junction field-effect transistor, trench MOSFET or vertical MOSFET.

### Preferred embodiments

In one preferred embodiment of the invention a semiconductor device (10) is provided comprising: a substrate (11); a nitride semiconductor layer (103) arranged on the substrate (11); a blind via (12) being an electrical connection from a rear side or a backside (B) of the substrate (11) to the nitride semiconductor layer (103), the blind via (12) comprising a thin-film coating of a metal contact, the thin-film coating being arranged substantially in a hole (13) of said blind via (12) through the substrate (11) to said nitride semiconductor layer (103); a first electrical insulator (107) separating a portion of the thin-film coating from the substrate (12), wherein at least a part of the first electrical insulator (107) is part of a lateral wall of the hole (13), and a second electrical insulator (109) on the backside (B) of the substrate (11) electrically separating said substrate from a portion (105a) of said thin-film coating. The substrate may be silicon carbide or silicon.

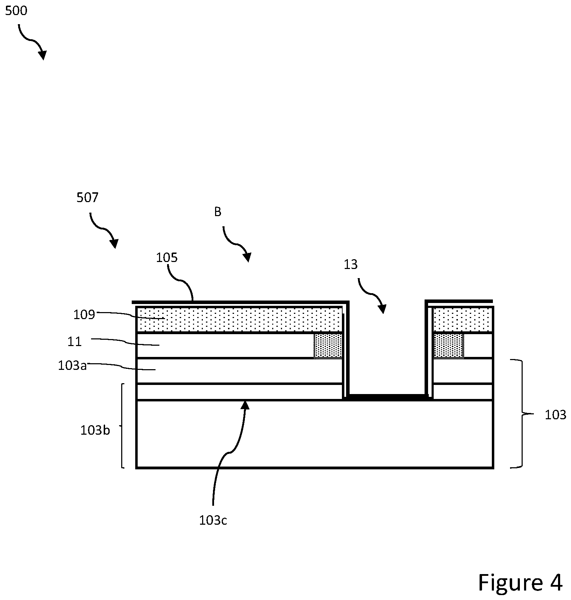

The above is illustrated in Fig. 4. Fig. 4 shows the metal contact (105) being arranged as a thin-film coating, the thin-film coating abutting the second electrical insulator (109) and the nitride semiconductor layer (103). The thin-film coating may further, as illustrated abut the first electrical insulator (107). Thus, the thin-film coating may conformally coat the hole (13) through the substrate (11) to the nitride semiconductor layer (103). The thin-film coating may have a uniform thickness less than 5 micrometers. The thickness of the thin-film coating on the first electrical insulator (107) may be the same as on the second electrical insulator (109), as illustrated.

Although modifications and changes may be suggested by those skilled in the art, it is the intent of the inventor to, within the scope of the disclosure herein, that the invention encompasses the scope of all modifications and modifications which reasonably and properly fall within the scope of the disclosure disclosed herein. The present invention has been described above with reference to specific embodiments. However, other embodiments than the above described are equally possible within the scope of the invention. Different method steps than those described above, may be provided within the scope of the invention. The different features and steps of the invention may be combined in other combinations than those described. For example, various features of embodiments may be combined in combinations other than those described mutatis mutandis. The scope of the invention is limited only by the appended claims.

## Claims

1. A semiconductor device comprising (10):
a substrate (11);
a nitride semiconductor layer (103) arranged on the substrate (11);
a blind via (12) being an electrical connection from a backside (B) of the substrate (11) to the nitride semiconductor layer (103), the blind via (12) comprising a first portion (105a) of a metal contact (105), the first portion (105a) being arranged in a hole (13) through the substrate (11);
a first electrical insulator (107) separating the first portion (105a) of the metal contact from the substrate (12), wherein at least a part of the first electrical insulator (107) is part of a lateral wall of the hole (13).

2. The device (10) according to claim 1, wherein the substrate (11) is a silicon substrate and the first electrical insulator (107) comprises silicon oxide.

3. The device (10) according to any one of claims 1 or 2, wherein the first electrical insulator (107) is an oxidized lateral wall of the hole (13) facing the first portion (105a) of the metal contact (105).

4. The device (10) according to any one of claims 1 to 3, wherein the metal contact (105) further comprises a second portion (105b), the second portion (105b) extending along the backside of the substrate (11), wherein the device (10) further comprises a second electrical insulator (109) arranged on the backside (B) of the substrate (11), between the backside (B) of the substrate (11) and the second portion (105b) of the metal contact (105).

5. The device (10) according to claim 4, wherein the metal contact (105) is arranged as a thin-film coating, the thin-film coating abutting the second electrical insulator (109) and the nitride semiconductor layer (103), the thin-film coating having a uniform thickness less than 5 micrometers.

6. The device (10) according to any one of claims 1 to 5, wherein the nitride semiconductor layer (103) comprises a first layer (103a) and a second layer (103b), the first layer (103a) being arranged between the second layer (103b) and the substrate (11) , wherein the first layer (103a) has a higher aluminum content than the second layer (103b).

7. The device (10) according to any of claim 1 to 6, wherein a thickness of the first electrical insulator (107) is 100-500 nm the thickness of the first electrical insulator (107) being a thickness separating the first portion (105a) of the metal contact (105) from the substrate (11).

8. A method (500) for producing a semiconductor device, the method comprising:
forming (501) a nitride semiconductor layer (103) on a frontside of a substrate (11);
forming (503) a hole (13) through the substrate, from the backside (B) of the substrate (11) to the nitride semiconductor layer (103);
forming (505) a first electrical insulator (107), such that at least a part of the first electrical insulator (107) is part of a lateral wall of the hole (13);
depositing (509) metal on the backside (B) of the substrate to form a metal contact (105), the metal contact (105) having a first portion (105a) in the hole (13) through the substrate (11), such that the first portion (105a) of the metal contact (105) forms part of a blind via (12) being an electrical connection from the backside (B) of the substrate (11) to the nitride semiconductor layer (103), wherein the first electrical insulator (107) separates the first portion (105a) of the metal contact from the substrate (11).

9. The method (500) according to claim 8, wherein the hole (13) is formed by plasma etching, such as deep reactive ion etching.

10. The method (500) according to any one of claims 8 and 9, wherein the forming (505) of the first electrical insulator (107) is made by oxidizing the lateral wall of the hole (13).

11. The method (500) according to claim 8, wherein oxidizing the lateral wall of the hole (13) is done by dry oxidation using an oxygen plasma.

12. The method (500) according to any one of claims 8 to 11, wherein the method (500) further comprises: depositing (502) a second electrical insulator (109) on the backside (B) of the substrate (11) before forming the hole (13).

13. The method (500) according to any one of claim 8 to 12, wherein the nitride semiconductor layer (103) comprises a first layer (103a) and a second layer (103b), the first layer (103a) being arranged between the second layer (103b) and the substrate, wherein the first layer (103a) has a higher aluminum content than the second layer (103b), wherein the first layer (103a) of the nitride semiconductor layer (103) is formed by sputtering.

14. The method (500) according to any one of claims 8 to 13, wherein the method further comprises, after forming (505) the first electrical insulator (107) and before depositing (509) metal,
expanding the hole (13) into the nitride semiconductor layer (103).

15. The method (500) according to claim 14, wherein the nitride semiconductor layer (103) comprises an etch stop layer (103c) and wherein the method further comprises:
stopping the expansion of the hole (13) at the etch stop layer.

16. The method (500) according to claim 14, wherein the in situ etch stop (103c) is an In(z)Ga(1-z)N epilayer.
